# FASCICULE DE BREVET EUROPEEN

(11) **EP 3 059 772 B1**
(45) Date de publication et mention de la délivrance du brevet: **14.03.2018**
(21) Numéro de dépôt: 16155595.8
(22) Date de dépôt: 12.02.2016
(51) Int. Cl.: H01L 41/047, H01L 41/08, G01L 9/08

(54) **DISPOSITIF PIÉZOÉLECTRIQUE**
PIEZOELEKTRISCHE VORRICHTUNG
PIEZOELECTRIC DEVICE

(30) Priorité: 23.02.2015 FR 1551520
(43) Date de publication de la demande: 24.08.2016
(73) Titulaire: COMMISSARIAT À L'ÉNERGIE ATOMIQUE ET AUX ÉNERGIES ALTERNATIVES, 75015 Paris (FR)
(72) Inventeur: ALIANE, Abdelkader, 38100 GRENOBLE (FR); GALLIARI, Marine, 38000 GRENOBLE (FR); TOURNON, Laurent, 38120 SAINT EGREVE (FR)
(74) Mandataire: Thibon, Laurent

(56) Documents cités:
- EP-B1- 1 021 843
- EP-B1- 1 983 584
- WO-A1-2006/057987
- FR-A1- 2 989 485

## Description

### Domaine

La présente demande concerne un dispositif piézoélectrique à base de matériaux organiques, notamment un capteur de pression, et un procédé de fabrication d'un tel dispositif.

### Exposé de l'art antérieur

La demande de brevet WO2006/057987 décrit un capteur de pression comprenant un film piézoélectrique en un matériau organique formé sur un substrat et recouvert de deux électrodes interdigitées. Lorsqu'une pression est exercée sur le substrat, des contraintes mécaniques sont appliquées au film piézoélectrique entraînant la génération de charges électriques dans celui-ci. Ces charges électriques sont récupérées par les électrodes et permettent l'obtention d'un signal électrique représentatif de la pression.

Un inconvénient du capteur de pression décrit dans la demande de brevet WO2006/057987 est qu'il n'est pas adapté à la mesure de pressions élevées, notamment supérieures à 10 mbar (1000 Pa), par exemple pour une utilisation dans un compteur d'eau. En effet, l'application de contraintes mécaniques élevées dans le film piézoélectrique peut entraîner le décollement du film par rapport au substrat et/ou des électrodes par rapport au film, rendant le capteur de pression non opérationnel
Des autres capteurs/transducteurs piézoélectriques ayant des électrodes interdigitées sont connus de EP 1 021 843 B1, EP 1 983 584 B1 et FR 2 989 485 A1.

### Résumé

Un objet d'un mode de réalisation est de pallier tout ou partie des inconvénients des dispositifs piézoélectriques, notamment des capteurs de pression, comprenant un film piézoélectrique organique décrits précédemment.

Un autre objet d'un mode de réalisation est que le dispositif piézoélectrique est adapté à une utilisation comme capteur de pression, notamment pour la mesure de pressions élevées supérieures à 10 mbar (1000 Pa) et allant, notamment, jusqu'à 20 bars (2 MPa).

Un autre objet d'un mode de réalisation est que le dispositif piézoélectrique peut être fabriqué à bas coût.

Un autre objet d'un mode de réalisation est que le dispositif piézoélectrique peut être réalisé, au moins en partie, par des techniques d'impression.

Un autre objet d'un mode de réalisation est que le dispositif piézoélectrique peut être réalisé sur un substrat flexible.

Ainsi, un mode de réalisation prévoit un dispositif piézoélectrique comprenant :
un substrat ;
au moins deux électrodes s'étendant sur le substrat ;
au moins une bande piézoélectrique s'étendant sur le substrat et sur les électrodes ; et
au moins une bande conductrice électriquement s'étendant au moins sur l'une des électrodes et sur la bande piézoélectrique et au contact du substrat de part et d'autre de la bande piézoélectrique.

Selon un mode de réalisation, le dispositif comprend au moins deux cavités traversantes dans ladite électrode, la bande piézoélectrique s'étendant entre les cavités et la bande conductrice s'étendant dans chaque cavité au contact du substrat.

Selon un mode de réalisation, chaque électrode comprend des doigts, les doigts des électrodes étant interdigités, le capteur comprenant, en outre, des bandes piézoélectriques s'étendant chacune sur le substrat et sur les doigts, et des bandes conductrices électriquement s'étendant sur les doigts et sur les bandes piézoélectriques, chaque bande conductrice étant au contact du substrat de part et d'autre de chaque bande piézoélectrique.

Selon un mode de réalisation, le dispositif comprend des cavités traversantes dans chaque doigt, et, pour chaque doigt, chaque bande piézoélectrique s'étend entre deux cavités adjacentes du doigt, et chaque bande conductrice s'étend dans chaque cavité de l'un des doigts, au contact du substrat.

Selon un mode de réalisation, chaque bande piézoélectrique comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

Selon un mode de réalisation, chaque bande conductrice est en un premier matériau organique.

Selon un mode de réalisation, le premier matériau organique comprend plus de 90 % en poids de carbone.

Selon un mode de réalisation, le substrat est en un deuxième matériau organique.

Selon un mode de réalisation, le deuxième matériau organique est choisi parmi le groupe comprenant le polyéthylène naphtalate, le polyéthylène téréphtalate, le polyimide et le polyétheréthercétone.

Selon un mode de réalisation, chaque cavité s'étend, en outre, dans le substrat sur une partie de l'épaisseur du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B et 1C sont respectivement une vue de dessus et des vues en coupe de côté selon deux plans de coupe perpendiculaires, partielles et schématiques, d'un mode de réalisation d'un capteur de pression ;
les figures 2A, 2B et 2C sont des vues analogues aux figures 1A, 1B et 1C respectivement après une étape d'un mode de réalisation d'un procédé de fabrication du capteur de pression représenté sur les figures 1A, 1B et 1C ;
les figures 3A, 3B et 3C sont des vues analogues aux figures 2A, 2B et 2C respectivement après une étape ultérieure d'un mode de réalisation d'un procédé de fabrication du capteur de pression représenté sur les figures 1A, 1B et 1C ;
les figures 4A, 4B et 4C sont des vues analogues aux figures 3A, 3B et 3C respectivement après une étape ultérieure d'un mode de réalisation d'un procédé de fabrication du capteur de pression représenté sur les figures 1A, 1B et 1C ;
les figures 5A, 5B et 5C sont des vues analogues aux figures 4A, 4B et 4C respectivement après une étape ultérieure d'un mode de réalisation d'un procédé de fabrication du capteur de pression représenté sur les figures 1A, 1B et 1C ;
la figure 6 représente une courbe d'évolution de la tension fournie par un capteur de pression selon le mode de réalisation représenté sur les figures 1A, 1B et 1C en fonction de la pression exercée sur le substrat du capteur ; et
la figure 7 est une vue de dessus des électrodes d'un capteur de pression selon un autre mode de réalisation.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, les dispositifs de traitement des signaux fournis par le capteur de pression sont bien connus de l'homme du métier et ne sont pas décrits en détail. Sauf précision contraire, les expressions "approximativement", "sensiblement", et "de l'ordre de" signifient à 10 % près, de préférence à 5 % près. Dans la suite de la description, l'expression élément "à base de polyfluorure de vinylidène (PVDF)" signifie un copolymère comprenant au moins 70 % en masse molaire du monomère fluorure de vinylidène (VDF) et éventuellement d'au moins un autre monomère comme par exemple le trifluoroéthylène (TrFE) ou le tétrafluoroéthylène (TFE).

Des modes de réalisation d'un dispositif piézoélectrique vont être décrits adaptés à la réalisation d'un capteur de pression. Toutefois, il est clair que le dispositif piézoélectrique peut être utilisé pour d'autres applications, par exemple pour la réalisation d'un dispositif de récupération d'énergie.

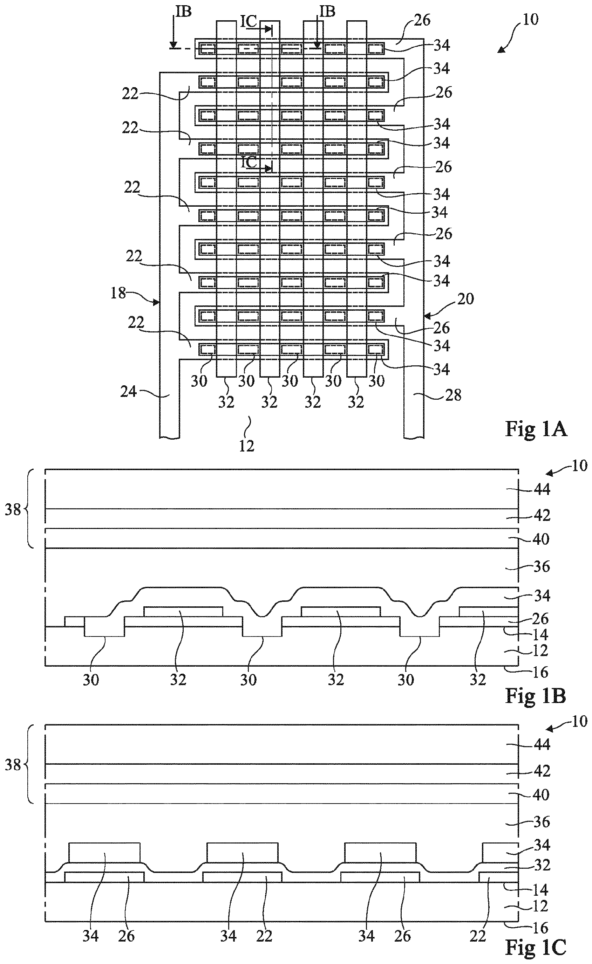

Les figures 1A, 1B et 1C sont respectivement une vue de dessus et des vues en coupe de côté, partielles et schématiques, d'un mode de réalisation d'un capteur de pression 10. Les plans de coupe des figures 1B et 1C sont perpendiculaires. Sur la figure 1A, certaines couches du capteur de pression 10 ne sont pas représentées. En outre, sur la figure 1A, les contours d'un élément recouvert par un autre élément sont représentés en traits pointillés.

Le capteur de pression 10 comprend, du bas vers le haut sur les figures 1B et 1C :
un substrat 12 comprenant deux faces 14, 16 opposées ;
deux électrodes interdigitées 18, 20 s'étendant sur la face 14 du substrat 12 en contact avec la face 14 du substrat 12, l'électrode 18 n'étant pas en contact avec l'électrode 20, l'électrode 18 comprenant des doigts 22 parallèles reliés à une piste 24 et l'électrode 20 comprenant des doigts 26 parallèles aux doigts 22 et reliés à une piste 28, chaque doigt 22, éventuellement à l'exception d'un ou de deux doigts 22, étant intercalé entre deux doigts 26 et chaque doigt 26, éventuellement à l'exception d'un ou de deux doigts 26, étant intercalé entre deux doigts 22 ;
des cavités 30 traversant chaque doigt 22, 26 de part en part et se prolongeant dans le substrat 12 depuis la face 14 sur une partie de l'épaisseur du substrat 12 ;
des bandes 32 parallèles d'un matériau organique et piézoélectrique s'étendant sur les doigts 22 et 26 et sur la face 14 du substrat 12 entre les doigts 22, 26, et au contact des doigts 22, 26 et de la face 14 du substrat 12, les bandes piézoélectriques 32 étant orientées de façon sensiblement perpendiculaire aux doigts 22, 26 ;
des bandes 34 parallèles d'un matériau organique et conducteur électriquement, les bandes 34 étant orientées de façon parallèle aux doigts 22, 26, chaque bande 34 s'étendant sur l'un des doigts 22 ou 26, et recouvrant les parties des bandes 32 situées sur ledit doigt 22, 26 et recouvrant les portions dudit doigt 22, 26 sous-jacent entre les bandes 32 ;
une couche d'encapsulation 36, non représentée en figure 1A, recouvrant les bandes 34, les bandes 32, les électrodes 18, 20 et le substrat 12 ; et
éventuellement un revêtement 38, non représenté en figure 1A, recouvrant la couche d'encapsulation 36 et comprenant successivement, du bas vers le haut sur les figures 1B et 1C, une couche adhésive 40, une couche barrière 42 et une couche de protection 44.

L'épaisseur du substrat 12 peut être comprise entre 100 nm et 1000 µm, de préférence entre 25 µm et 300 µm. Le substrat 12 peut être un substrat rigide ou un substrat flexible. Un substrat flexible peut, sous l'action d'une force extérieure, se déformer, notamment se plier, sans se casser ou se déchirer. Un exemple de substrat rigide comprend un substrat en silicium, en germanium ou en verre. Un exemple de substrat flexible comprend un film en PEN (polyéthylène naphtalate), PET (polyéthylène téréphtalate), PI (polyimide) ou PEEK (polyétheréthercétone). De préférence, le substrat 12 est un film flexible. Il a alors, de préférence, une épaisseur comprise entre 100 nm et 10 µm.

Les électrodes 18, 20 peuvent être en oxyde d'étain et d'indium, en un matériau métallique, notamment l'argent, l'or, le nickel, le palladium, le platine, l'aluminium, le cuivre, le titane ou un alliage ou un mélange d'au moins deux de ces matériaux, en un polymère conducteur, par exemple le poly(3, 4-éthylènedioxythiophène) : poly(styrène sulfonate) (PEDOT : PSS) ou en graphène.

Les dimensions des électrodes 18, 20 sont adaptées à l'application envisagée. A titre d'exemple, chaque électrode 18, 20 peut comprendre au moins deux doigts, notamment environ 5 doigts. La longueur de chaque doigt 22, 26 peut varier de 20 µm à 10000 µm, notamment environ 4000 µm. La largeur de chaque doigt 22, 26 peut varier de 20 µm à 300 µm, notamment environ 50 µm. L'écartement entre un doigt 22 de l'électrode 18 et le doigt de l'électrode 20 le plus proche peut varier de 1 µm à 200 µm, par exemple environ 2 µm. L'épaisseur de chaque doigt 22, 26 peut varier de 10 nm à 300 nm, par exemple environ 100 nm.

Les cavités 30 peuvent avoir, en vue de dessus, une forme circulaire, elliptique ou polygonale, notamment carrée ou rectangulaire. A titre d'exemple, les cavités 30 peuvent, en vue de dessus, avoir la forme d'un rectangle dont le grand côté mesure de 10 µm à 900 µm, notamment environ 300 µm et le petit côté mesure de 5 µm à 300 µm, notamment environ 100 µm.

Les bandes piézoélectriques 32 peuvent être réalisées en un composé à base de PVDF. Le composé à base de PVDF peut comprendre le seul polymère PVDF, un seul copolymère du PVDF, un mélange de deux ou plus de deux copolymères du PVDF, un mélange du polymère PVDF et d'au moins un copolymère du PVDF. De préférence, le copolymère du PVDF est le poly(fluorure de vinylidène - tri fluoro éthylène) (P(VDF-TrFE)), notamment le P(VDFₓ-TrFE₁₀₀₋ₓ) où x est un nombre réel compris entre 60 et 80, notamment environ 70, le poly(fluorure de vinylidène - tétrafluoroéthylène), le poly((fluorure de vinylidène - trifluoroéthylène - chlorofluoroéthylène) (P(VDF-TrFE-CFE) ou le poly((fluorure de vinylidène - trifluoroéthylène - chlorotrifluoro éthylène) (P(VDF-TrFE-CTFE).

Le composé à base de PVDF peut, en outre, comprendre des charges. Les charges peuvent correspondre à des particules céramiques, par exemple des particules de titanate de baryum (BaPiO₃), des particules de zirconate titanate de plomb (PbZrTiO₃ ou PZT), des particules de titanate de plomb (PbTiO₃) ou des particules de tantalate de lithium (LiTaO₃). La concentration en poids de charges dans le composé à base de PVDF peut varier de 5 % à 25 %.

Le composé peut donc comprendre un mélange du polymère PVDF et d'au moins une céramique ou un mélange d'au moins un copolymère du PVDF et d'au moins une céramique, par exemple les mélanges suivants : PVDF/BaTiO₃, P(VDF-TrFE)/BaTiO₃, P(VDF-TrFE-CTFE)/BaTiO₃, P(VDF-TrFE-CFE)/BaTiO₃, PVDF/PbZrTiO₃, P(VDF-TrFE)/PbZrTiO₃, P(VDF-TrFE-CTFE)/PbZrTiO₃, P(VDF-TrFE-CFE)/PbZrTiO₃, PVDF/PbTiO₃, P(VDF-TrFE)/PbTiO₃, P(VDF-TrFE-CTFE)/PbTiO₃, P(VDF-TrFE-CFE)/PbTiO₃, PVDF/LiTaO₃, P(VDF-TrFE)/LiTaO₃, P(VDF-TrFE-CTFE)/LiTaO₃, P(VDF-TrFE-CFE)/LiTaO₃.

La largeur de chaque bande piézoélectrique 32 peut varier de 20 µm à 300 µm, par exemple environ 100 µm. L'écartement entre deux bandes 32 adjacentes peut varier de 10 µm à 500 µm, par exemple environ 400 µm. L'épaisseur de chaque bande 32 peut varier de 100 nm à 10 µm, par exemple environ 4 µm.

Les bandes conductrices 34 peuvent être réalisées en un matériau carboné conducteur électriquement. Un matériau carboné est un matériau comprenant plus de 80 %, de préférence plus de 90 %, en poids de carbone. Le matériau carboné peut correspondre au produit obtenu après le séchage d'une encre carbone ou peut correspondre à du graphène conducteur ou à un mélange entre du noir de carbone et une encre argent. L'encre carbone peut être l'encre carbone commercialisée par la société Creative Materials sous l'appellation 112-48. De préférence, le matériau carboné a un module d'Young inférieur à 10 GPa. La résistance par carré de chaque bande conductrice 34 varie de 1 ohm/□ à 50 ohm/□. Le matériau composant les bandes conductrices 24 a une bonne adhérence sur le substrat 12. Selon un mode de réalisation, la force de pelage d'une bande conductrice 34, selon un angle de pelage supérieur à 45°, adhérant sur le substrat 12 est supérieure à 30 N pour une largeur d'adhésif de 25 mm.

La longueur de chaque bande conductrice 34 peut être sensiblement la même que celle d'un doigt 22, 26, par exemple de 50 µm à 10000 µm, par exemple environ 4000 µm. La largeur de chaque bande conductrice 34 peut être sensiblement la même que celle d'un doigt 22, 26, par exemple de 20 µm à 300 µm, par exemple environ 100 µm. L'épaisseur de chaque bande conductrice 34 peut varier de 1 µm à 20 µm, par exemple environ 4 µm.

La couche d'encapsulation 36 peut être en polydiméthyl-siloxane (PDMS) ou en poly(méthacrylate de méthyle) (PMMA). L'épaisseur de la couche d'encapsulation 36 peut varier de 10 µm à 2 mm.

La couche adhésive 40 peut être en un adhésif sensible à la pression (PSA, sigle anglais pour Pressure Sensitive Adhesive). Des exemples d'adhésifs sensibles à la pression sont à base de polyacrylates, de polydiènes, ou à base de polymères triblocs comme le styrène-isoprène-styrène (SIS) ou le styrène-butadiène-styrène (SBS). De préférence, le matériau composant la couche d'encapsulation 36 a un module d'Young inférieur à 1 GPa. L'épaisseur de la couche adhésive peut être d'environ 25 µm.

La couche barrière 42 peut comprendre un empilement d'au moins une couche d'un matériau inorganique et d'au moins une couche d'un matériau organique. Des exemples de matériaux inorganiques sont le nitrure de silicium, le nitrure d'aluminium, l'oxyde d'aluminium, l'oxyde de silicium et les mélanges d'au moins deux de ces composés. Des exemples de matériaux organiques sont les polyacrylates. L'épaisseur de la couche barrière 42 peut varier de 10 nm à 500 nm.

La couche de protection 44 peut comprendre un film flexible en PEN (polyéthylène naphtalate), PET (polyéthylène téréphtalate), PI (polyimide) ou PEEK (polyétheréthercétone). La couche de protection 44 a, de préférence, une épaisseur comprise entre 10 µm et 50 µm.

En fonctionnement, lorsqu'une pression est appliquée au substrat 12, les bandes piézoélectriques 32 sont déformées principalement selon une direction parallèle à la face 14 du substrat 12, c'est-à-dire que les bandes piézoélectriques fonctionnent principalement selon un mode transversal {31}.

Chaque bande conductrice 34 est ancrée au substrat 12 par les zones de contact entre chaque bande conductrice 34 et le substrat 12 dans les cavités 30. De ce fait, chaque bande conductrice 34 participe à maintenir les bandes piézoélectriques 32 en appui contre les électrodes 18, 20 et le substrat 12 et à maintenir les doigts 22, 26 en appui contre le substrat 12. Les bandes conductrices 34 réduisent donc les risques de décollement des bandes piézoélectriques 32 et/ou des électrodes 18, 20 lorsque les contraintes mécaniques exercées sur les bandes piézoélectriques 32 sont élevées. Le capteur de pression 10 peut notamment permettre la mesure de pressions variant de 10 mbar (1000 Pa) à environ 20 bars (2*10⁶ Pa).

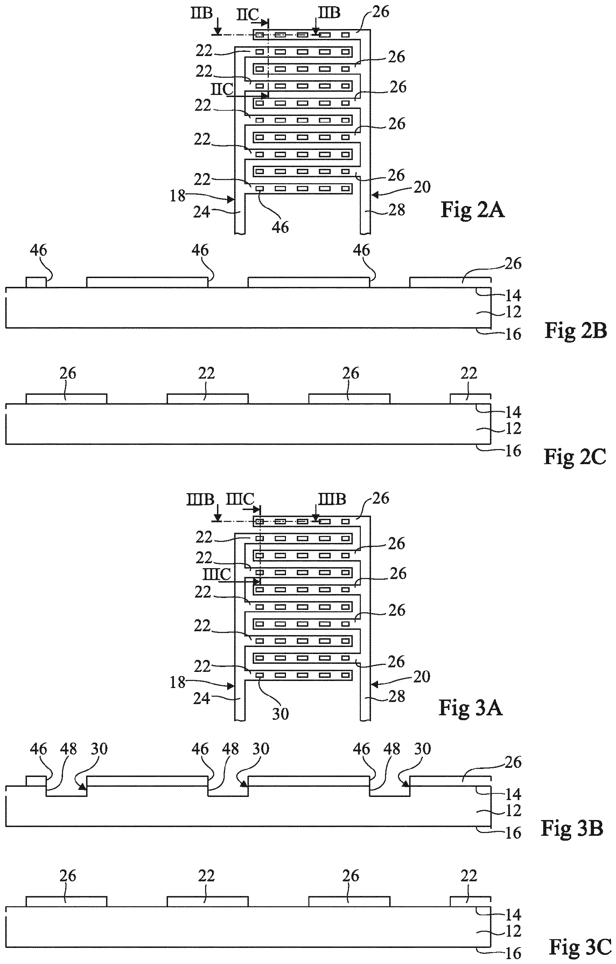

Un mode de réalisation d'un procédé de fabrication du capteur 10 va maintenant être décrit en relation avec les figures 2A à 5C.

Les figures 2A, 2B et 2C sont des vues analogues aux figures 1A, 1B et 1C respectivement après avoir formé les électrodes 18, 20 sur le substrat 12. Selon le matériau composant les électrodes 18, 20, le procédé de formation des électrodes 18, 20 peut correspondre à un procédé dit additif, par exemple par impression directe d'une composition fluide ou visqueuse comprenant le matériau composant les électrodes 18, 20 aux emplacements souhaités, par exemple par impression par jet d'encre, héliographie, sérigraphie, flexographie, revêtement par pulvérisation (en anglais spray coating) ou dépôt de gouttes (en anglais drop-casting). Selon le matériau composant les électrodes 18, 20, le procédé de formation des électrodes 18, 20 peut correspondre à un procédé dit soustractif, dans lequel le matériau composant les électrodes 18, 20 est déposé sur la totalité de la structure et dans lequel les portions non utilisées sont ensuite retirées, par exemple par photolithographie ou ablation laser. Selon le matériau considéré, le dépôt sur la totalité de la structure peut être réalisé, par exemple, par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Selon le procédé de dépôt mis en oeuvre, une étape de séchage des matériaux déposés peut être prévue.

Lorsque la formation des électrodes 18, 20 comprend une étape de dépôt physique en phase vapeur, le procédé comprend le dépôt d'une couche conductrice sur la face 14 du substrat 12 et la gravure de cette couche pour délimiter les électrodes 18, 20. La gravure peut comprendre une étape de photolithographie. A titre d'exemple, dans le cas où les électrodes 18, 20 sont en or, la gravure peut être une gravure chimique avec de l'iodure de potassium. En particulier, l'étape de gravure entraîne la formation d'ouvertures 46 dans chaque doigt 22, 26 qui exposent des portions de la face 14 du substrat 12.

Les figures 3A, 3B et 3C sont des vues analogues aux figures 2A, 2B et 2C respectivement après une étape de gravure d'ouvertures 48 dans le substrat 12 dans le prolongement des ouvertures 46. La profondeur de chaque ouverture 48 peut varier de 1 µm à 10 µm. La gravure des ouvertures 48 peut comprendre une étape de photolithographie. Les ouvertures 46 et 48 forment les cavités 30 décrites précédemment. Dans le cas où le substrat 12 est en PEN, la gravure peut être une gravure utilisant un plasma d'oxygène.

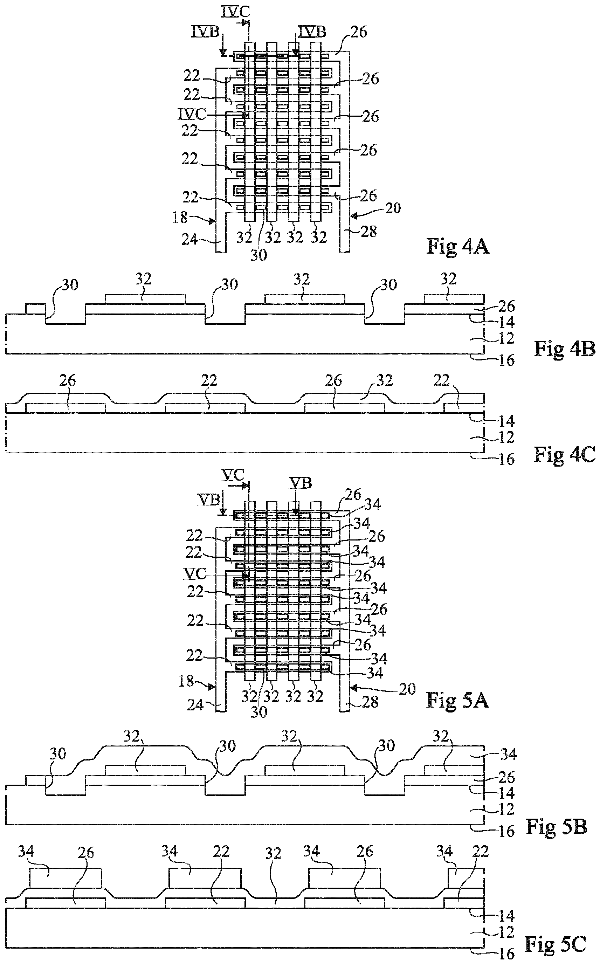

Les figures 4A, 4B et 4C sont des vues analogues aux figures 3A, 3B et 3C respectivement après la formation des bandes piézoélectriques 32. Le procédé peut comprendre le dépôt d'une première composition liquide, éventuellement visqueuse puis une étape de cristallisation du composé à base de PVDF pour former les bandes piézoélectriques 32.

La première composition liquide comprend un premier solvant et un composé à base de PVDF dissous dans le premier solvant. De préférence, le premier solvant est un solvant polaire. Ceci permet, de façon avantageuse, d'améliorer la dissolution du polymère à base de PVDF. De préférence, le premier solvant est adapté à absorber, au moins partiellement, le rayonnement UV, par exemple sur une plage de longueurs d'onde comprises entre 200 nm et 400 nm. Selon un mode de réalisation, la température d'évaporation du premier solvant est comprise entre 110°C et 140°C, de préférence entre 110°C et 130°C, plus préférentiellement entre 120°C et 130°C. Le premier solvant peut être choisi parmi le groupe comprenant le cyclopentanone, le diméthylsulphoxide (DMSO), le diméthylformamide (DMF), le diméthylacétamide (DMAc) ou le N-méthyl-E-pyrrolidone (NMP). De préférence, le premier solvant est le cyclopentanone.

La première composition peut comprendre de 1 % à 30 %, de préférence de 1 % à 30 %, de préférence de 10 % à 25 %, notamment environ 20 %, en poids du composé à base de PVDF et de 70 % à 99 %, de préférence de 75 % à 90 %, notamment environ 80 %, en poids du premier solvant. De façon avantageuse, la concentration en poids du premier solvant est choisie pour ajuster la viscosité de la première composition obtenue afin de permettre la mise en oeuvre de techniques d'impression. Le procédé de formation des bandes piézoélectriques 32 peut correspondre à un procédé dit additif tel que décrit précédemment, notamment par jet d'encre, sérigraphie ou revêtement par pulvérisation. Le procédé de formation des bandes piézoélectriques 32 peut, en outre, correspondre à un procédé dit soustractif tel que décrit précédemment. Lorsque le procédé de dépôt comprend une étape de sérigraphie, la viscosité de la première composition peut varier de 5 Pa.s à 30 Pa.s.

L'étape de cristallisation du composé à base de PVDF peut comprendre un recuit réalisé à une température comprise entre 100°C et 130°C pendant 10 minutes à 30 minutes. Selon un autre mode de réalisation, l'étape de cristallisation peut comprendre l'irradiation de la première composition aux rayons ultraviolets (UV) par une succession d'impulsions de rayonnement UV, ou flashs ultraviolets. Par rayonnement UV, on entend un rayonnement dont les longueurs d'onde sont, au moins en partie, comprises entre 200 nm et 400 nm. Selon un mode de réalisation, la durée d'une impulsion UV est comprise entre 500 µs et 2 ms. La durée entre deux impulsions UV successives peut être comprise entre 1 et 5 secondes. La fluence du rayonnement UV peut être comprise entre 10 J/cm² et 25 J/cm². Le nombre d'impulsions UV dépend notamment de l'épaisseur des bandes piézoélectriques 32. A titre d'exemple, pour une épaisseur des bandes piézoélectriques 32 de 100 nm, le nombre d'impulsions UV peut être de l'ordre de 1 à 2 avec une fluence entre 10 J/cm² et 15 J/cm² et pour une épaisseur des bandes piézoélectriques 32 de l'ordre de 4 µm, le nombre d'impulsions UV peut être de l'ordre de 2 à 6 avec une fluence entre 17 J/cm² et 21 J/cm².

De façon avantageuse, pendant l'irradiation de la première composition, les électrodes 18, 20 réfléchissent une partie du rayonnement UV ayant traversé la première composition. Ceci permet d'améliorer la quantité de rayonnement UV reçue par la première composition. De façon avantageuse, le premier solvant de la première composition absorbe au moins en partie le rayonnement UV. Ceci permet d'améliorer le chauffage du composé à base d'UV et de favoriser la formation de la phase cristalline β, qui est la phase pouvant présenter des propriétés pyroélectriques et piézoélectriques. La température d'évaporation du premier solvant est avantageusement supérieure à 110°C pour éviter une évaporation trop rapide du premier solvant avant la formation de la phase cristalline qui se produit entre 120°C et 130°C. De préférence, l'étape d'irradiation entraîne une évaporation de plus de 50 % en poids, de préférence de plus de 80 % en poids, du premier solvant de la première composition.

Les figures 5A, 5B et 5C sont des vues analogues aux figures 4A, 4B et 4C respectivement après une étape de formation des bandes conductrices 34. Le procédé peut comprendre le dépôt d'une deuxième composition liquide, éventuellement visqueuse, puis une étape de séchage pour former les bandes conductrices 34. La deuxième composition liquide comprend un deuxième solvant et un composé à base d'un matériau carboné dissous dans le deuxième solvant. Le deuxième solvant est choisi pour ne pas réagir chimiquement avec le matériau formant les bandes piézoélectriques 32. Le deuxième solvant peut être choisi parmi le groupe comprenant le cyclohéxane, le chloroforme, le tétrahydrofurane, l'acétate d'éthyle et le xylène.

La deuxième composition peut comprendre de 5 % à 30 %, en poids du composé carboné et de 85 % à 70 %, en poids du deuxième solvant. De façon avantageuse, la concentration en poids du deuxième solvant est choisie pour ajuster la viscosité de la deuxième composition obtenue afin de permettre la mise en oeuvre de techniques d'impression. Le procédé de formation des bandes conductrices 34 peut correspondre à un procédé dit additif tel que décrit précédemment, notamment par jet d'encre, sérigraphie ou revêtement par pulvérisation. Le procédé de formation de la portion en la deuxième composition peut, en outre, correspondre à un procédé dit soustractif tel que décrit précédemment. L'étape de séchage de la deuxième composition peut comprendre un recuit réalisé à une température comprise entre 90°C et 130°C pendant 10 minutes à 30 minutes.

Une étape ultérieure du mode de réalisation de procédé de fabrication peut comprendre la formation de la couche d'encapsulation 36 sur la structure obtenue à l'étape précédente. La couche d'encapsulation 36 peut être déposée par sérigraphie. Une étape de recuit peut être prévue, par exemple à une température comprise entre 60°C et 80°C pendant une durée variant de 30 minutes à plusieurs heures.

Pour certaines applications, notamment lorsque le capteur 10 est placé dans un fluide aqueux, il peut être souhaitable d'améliorer la protection du capteur contre l'humidité. Un mode de réalisation du procédé de fabrication peut alors comprendre une étape supplémentaire de fixation du revêtement 38 à la couche d'encapsulation. L'empilement comprenant la couche de protection 44 et la couche barrière 42 peut être réalisé séparément et être fixé à la couche d'encapsulation par la couche adhésive 40, par exemple par une étape de laminage.

Pour certaines applications, pour améliorer les caractéristiques piézoélectriques des bandes 32 à base de PVDF, un champ électrique continu peut être appliqué aux bandes piézoélectriques 32 ayant une intensité qui varie entre 20 V/µm et 80 V/µm pendant plusieurs minutes à 25°C ou à une température plus élevée, par exemple entre 80°C et 100°C. Selon un autre mode de réalisation, les caractéristiques piézoélectriques des bandes 32 à base de PVDF peuvent être améliorées en appliquant un traitement Corona aux bandes piézoélectriques 32.

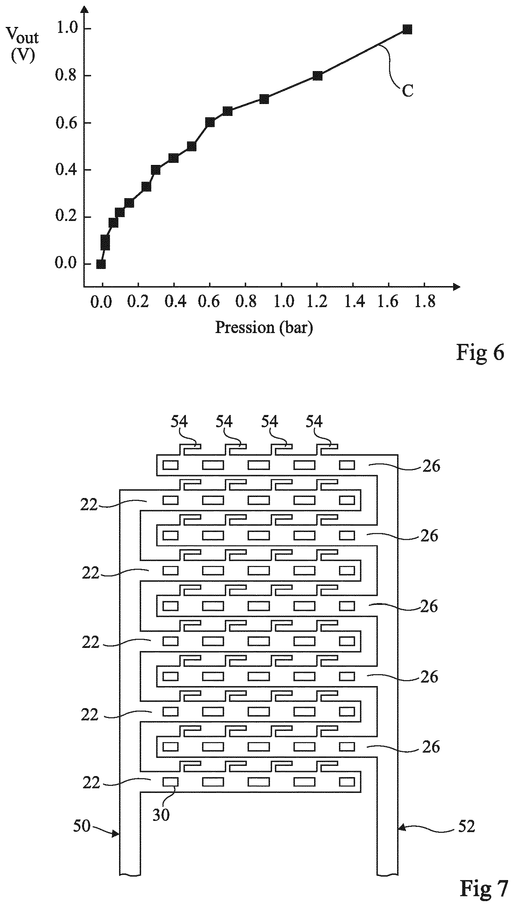

La figure 6 représente une courbe C d'évolution de la tension mesurée entre les électrodes 18, 20 du capteur de pression 10 en fonction de la pression appliquée au substrat 12. La courbe C a été obtenue pour un capteur de pression 10 ayant les dimensions et la structure suivantes :
le substrat 12 était en PEN et avait une épaisseur de 125 µm ;
les électrodes 18, 20 étaient en or, avaient une épaisseur de 30 nm et comprenaient chacune cinq doigts ayant chacun une longueur de 4000 µm et une largeur de 300 µm avec des cavités 30 ayant chacune, en vue de dessus, la forme d'un rectangle dont le grand côté mesure 300 µm et le petit côté mesure 100 µm ;
les bandes piézoélectriques 32 étaient en P(VDF₃₀-TrFE₇₀) et étaient au nombre de 4, espacées de 200 µm les unes des autres, avaient une largeur de 100 µm et une épaisseur de 4 µm ; et
les bandes conductrices 34 étaient en encre carbone et avaient une épaisseur de 4 µm.

La courbe C met en évidence le bon fonctionnement du capteur de pression 10 au moins jusqu'à une pression de 2 bars (0, 2 MPa).

La figure 7 est une vue de dessus, partielle et schématique, d'un autre mode de réalisation d'électrodes 50, 52. Les électrodes 50, 52 comprennent l'ensemble des éléments des électrodes 18, 20 décrites précédemment et comprennent, en outre, pour chaque doigt 22, 26, des ergots 54 qui sont connectés au doigt 22, 24 et s'étendent parallèlement entre le doigt auquel ils sont connectés et le doigt adjacent. Les ergots 54 ne sont pas connectés les uns aux autres. Chaque ergot 54 est recouvert en partie par l'une des bandes piézoélectriques 32. Selon un mode de réalisation, chaque électrode 50, 52 comprend, pour chaque doigt 22, 26, autant d'ergots 54 qu'il y a de bandes piézoélectriques 32. Les ergots 54 permettent d'améliorer la récupération par les électrodes 50, 52 des charges électriques produites dans les bandes piézoélectriques.

Des modes de réalisation particuliers ont été décrits. Diverses variantes et modifications apparaîtront à l'homme de l'art. En particulier, bien que dans les modes de réalisation décrits précédemment les cavités s'étendent dans le substrat 12 sur une partie de l'épaisseur du substrat, les cavités 30 peuvent ne pas pénétrer dans le substrat 12 mais s'arrêter en surface du substrat 12. Les bandes conductrices 34 sont alors ancrées à la face 14 du substrat 12 dans chaque cavité 30.

## Revendications

1. Dispositif piézoélectrique comprenant :
un substrat (12) ;
au moins deux électrodes (18, 20) s'étendant sur le substrat ;
au moins une bande piézoélectrique (32) s'étendant sur le substrat et sur les électrodes ; et
au moins une bande (34) conductrice électriquement s'étendant au moins sur l'une des électrodes et sur la bande piézoélectrique et au contact du substrat de part et d'autre de la bande piézoélectrique.

2. Dispositif selon la revendication 1, comprenant au moins deux cavités (30) traversantes dans ladite électrode (18, 20), la bande piézoélectrique (32) s'étendant entre les cavités et la bande conductrice (34) s'étendant dans chaque cavité au contact du substrat (12).

3. Dispositif selon la revendication 1 ou 2, dans lequel chaque électrode (18, 20) comprend des doigts (22, 26), les doigts des électrodes étant interdigités, le dispositif comprenant, en outre, des bandes piézoélectriques (32) s'étendant chacune sur le substrat (12) et sur les doigts, et des bandes (34) conductrices électriquement s'étendant sur les doigts et sur les bandes piézoélectriques, chaque bande conductrice étant au contact du substrat de part et d'autre de chaque bande piézoélectrique.

4. Dispositif selon la revendication 3, comprenant des cavités (30) traversantes dans chaque doigt (22, 26), et dans lequel, pour chaque doigt, chaque bande piézoélectrique (32) s'étend entre deux cavités adjacentes du doigt, et chaque bande conductrice (34) s'étend dans chaque cavité de l'un des doigts, au contact du substrat (12).

5. Dispositif selon l'une quelconque des revendications 1 à 4, dans lequel chaque bande piézoélectrique (32) comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

6. Dispositif selon l'une quelconque des revendications 1 à 5, dans lequel chaque bande conductrice (34) est en un premier matériau organique.

7. Dispositif selon la revendication 6, dans lequel le premier matériau organique comprend plus de 90 % en poids de carbone.

8. Dispositif selon la revendication 6 ou 7, dans lequel le substrat (12) est en un deuxième matériau organique.

9. Dispositif selon la revendication 8, dans lequel le deuxième matériau organique est choisi parmi le groupe comprenant le polyéthylène naphtalate, le polyéthylène téréphtalate, le polyimide et le polyétheréthercétone.

10. Dispositif selon l'une quelconque des revendications 1 à 9, dans lequel chaque cavité (30) s'étend, en outre, dans le substrat (12) sur une partie de l'épaisseur du substrat (12).

## Patentansprüche

1. Eine piezoelektrische Vorrichtung, die Folgendes aufweist:
ein Substrat (12);
wenigstens zwei Elektroden (18, 20), die sich auf dem Substrat erstrecken;
wenigstens ein piezoelektrischer Streifen (32), der sich auf dem Substrat und an den Elektroden erstreckt; und
wenigstens elektrisch leitfähiger Streifen (34), der sich auf wenigstens einer der Elektroden und auf dem piezoelektrischen Streifen erstreckt, und auf beiden Seiten des piezoelektrischen Streifens in Kontakt mit dem Substrat ist.

2. Die Vorrichtung nach Anspruch 1, die wenigstens zwei Durchgangsöffnungen (30) in der Elektrode (18, 20) aufweist, wobei sich der elektrische Streifen (32) zwischen den Öffnungen ersttreckt und der leitfähige Streifen (34) in jeder Öffnung in Kontakt mit dem Substrat (12) erstreckt.

3. Die Vorrichtung nach Anspruch 1 oder 2, wobei jede Elektrode (18, 20) Finger (22, 26) aufweist, wobei die Elektrodenfinger ineinandergreifen, wobei die Vorrichtung ferner piezoelektrische Streifen (32) aufweist, die sich jeweils auf dem Substrat (12) und auf den Fingern erstrecken, und elektrisch leitfähige Streifen (34) sich auf den Fingern und auf den piezoelektrischen Streifen erstrecken, wobei jeder leitfähige Streifen auf jeder Seite jedes piezoelektrischen Streifens in Kontakt mit dem Substrat ist.

4. Die Vorrichtung nach Anspruch 3, die Durchgangsöffnungen (30) in jedem Finger (22, 26) aufweist, und wobei für jeden Finger, sich jeder piezoelektrische Streifen (32) zwischen zwei benachbarten Öffnungen der Finger erstreckt, und jeder leitfähige Streifen (34) sich in jeder Öffnung eines der Finger erstreckt, und zwar in Kontakt mit dem Substrat (12).

5. Die Vorrichtung nach einem der Ansprüche 1 bis 4, wobei jeder piezoelektrische Streifen (32) Polyvinylidenfluorid und/oder wenigstens ein Copolymer aus Polyvinylidenfluorid aufweist, und insbesondere ein Polymer, das aus der Gruppe ausgewählt ist, die Polyvinylidenfluorid, Poly(vinylidenfluorid - trifluorethylen), Poly(vinylidenfluorid - tetrafluorethylen) und eine Mischung aus wenigstens zwei dieser Polymere aufweist.

6. Die Vorrichtung nach einem der Ansprüche 1 bis 5, wobei jeder leitfähige Streifen (34) aus einem ersten organischen Material hergestellt ist.

7. Die Vorrichtung nach Anspruch 6, wobei das erste organische Material mehr als 90 Gewichtsprozent Kohlenstoff aufweist.

8. Die Vorrichtung nach Anspruch 6 oder 7, wobei das Substrat (12) aus einem zweiten organischen Material hergestellt ist.

9. Die Vorrichtung nach Anspruch 8, wobei das zweite organische Material aus einer Gruppe ausgewählt ist, die Polyethylennaphthalat, Polythylenterephthalat, Polyimid und Polyetheretherketon aufweist.

10. Die Vorrichtung nach einem der Ansprüche 1 bis 9, wobei jede Öffnung (30) sich ferner in das Substrat (12) über einen Teil der Dicke des Substrats (12) hinein erstreckt.

## Claims

1. A piezoelectric device comprising:
a substrate (12);
at least two electrodes (18, 20) extending on the substrate;
at least one piezoelectric strip (32) extending on the substrate and on the electrodes; and
at least one electrically-conductive strip (34) extending at least on one of the electrodes and on the piezoelectric strip and in contact with the substrate on either side of the piezoelectric strip.

2. The device of claim 1, comprising at least two through cavities (30) in said electrode (18, 20), the piezoelectric strip (32) extending between the cavities and the conductive strip (34) extending in each cavity in contact with the substrate (12).

3. The device of claim 1 or 2, wherein each electrode (18, 20) comprises fingers (22, 26), the electrode fingers being interdigited, the device further comprising piezoelectric strips (32) each extending on the substrate (12) and on the fingers, and electrically-conductive strips (34) extending on the fingers and on the piezoelectric strip, each conductive strip being in contact with the substrate on either side of each piezoelectric strip.

4. The device of claim 3, comprising through cavities (30) in each finger (22, 26) and wherein, for each finger, each piezoelectric strip (32) extends between two adjacent cavities of the finger, and each conductive strip (34) extends in each cavity of one of the fingers, in contact with the substrate (12).

5. The device of any of claims 1 to 4, wherein each piezoelectric strip (32) comprises polyvinylidene fluoride and/or at least one copolymer of polyvinylidene fluoride, particularly a polymer selected from the group comprising polyvinylidene fluoride, poly(vinylidene fluoride - trifluoroethylene), poly(vinylidene fluoride - tetrafluoroethylene), and a mixture of at least two of these polymers.

6. The device of any of claims 1 to 5, wherein each conductive strip (34) is made of a first organic material.

7. The device of claim 6, wherein the first organic material comprises more than 90% by weight of carbon.

8. The device of claim 6 or 7, wherein the substrate (12) is made of a second organic material.

9. The device of claim 8, wherein the second organic material is selected from the group comprising polyethylene naphthalate, polyethylene terephthalate, polyimide, and polyetheretherketone.

10. The device of any of claims 1 to 9, wherein each cavity (30) further extends in the substrate (12) across a portion of the thickness of the substrate (12).
